# EUROPEAN PATENT SPECIFICATION

(11) **EP 0 676 793 B1**
(45) Date of publication and mention of the grant of the patent: **12.02.2003**
(21) Application number: 95302288.6
(22) Date of filing: 05.04.1995
(51) Int. Cl.: H01L 21/00, C23C 16/44, H01L 21/68

(54) **Substrate holder and reaction apparatus**
Substrathalter und Reaktionsvorrichtung
Porte substrat et dispositif de réaction

(30) Priority: 06.04.1994 JP 6879494
(43) Date of publication of application: 11.10.1995
(73) Proprietor: CANON SALES CO., INC., Minato-ku, Tokyo (JP); ALCAN-TECH CO., INC., Tokyo 108 (JP); SEMICONDUCTOR PROCESS LABORATORY CO., LTD., Minato-ku, Tokyo 108 (JP)
(72) Inventor: Maeda, Kazuo, c/o Semiconductor Process, Tokyo (JP); Ohira, Kouichi, c/o Semiconductor Process, Tokyo (JP); Nishimoto, Yuhko, c/o Semiconductor Process, Tokyo (JP)
(74) Representative: Whitaker, Iain Mark

(56) References cited:
- EP-A- 0 446 657
- EP-A- 0 493 089
- EP-A- 0 506 391
- WO-A-92/10308
- DE-A- 4 229 161
- GB-A- 2 229 454
- US-A- 5 084 125
- PATENT ABSTRACTS OF JAPAN vol. 008, no. 247 (E-278), 13 November 1984 & JP 59 124140 A (FUJITSU KK), 18 July 1984,
- PATENT ABSTRACTS OF JAPAN vol. 017, no. 221 (C-1054), 7 May 1993 & JP 04 358074 A (DENKI KAGAKU KOGYO KK), 11 December 1992,
- PATENT ABSTRACTS OF JAPAN vol. 013, no. 107 (C-576), 14 March 1989 & JP 63 282261 A (NEC CORP), 18 November 1988,
- PATENT ABSTRACTS OF JAPAN vol. 011, no. 190 (E-517), 18 June 1987 & JP 62 020321 A (HITACHI LTD), 28 January 1987,
- PATENT ABSTRACTS OF JAPAN vol. 013, no. 134 (C-581), 4 April 1989 & JP 63 297568 A (SHIMADZU CORP), 5 December 1988,
- PATENT ABSTRACTS OF JAPAN vol. 095, no. 001, 28 February 1995 & JP 06 280028 A (ANELVA CORP), 4 October 1994,

## Description

### BACKGROUND OF THE INVENTION

### 1. Field of the Invention

The present invention relates to a substrate holder and a reaction apparatus, and more specifically to a reaction apparatus for forming a film or etching the same that forms an insulating film or the like by using reaction gas and heating a substrate or performs etching, and a substrate holder for holding a substrate to be processed.

### 2. Description of the Prior Art

A CVD apparatus is a useful apparatus in forming a SiO₂ film, a PSG film, a BSG film, a BPSG film, a Si₃N₄ film, an amorphous Si film, a polycrystalline Si film, a W film, a Mo film, a WSi₂ film, a MoSi₂ film, an Aℓ film or the like in manufacture of a semiconductor device.

When conventional CVD apparatus are classified by means for activating reaction gas, principal apparatus include:
① thermal CVD apparatus,
② light-assisted CVD apparatus, and
③ plasma-assisted CVD apparatus.

The thermal CVD apparatus has heating means for supplying heat energy to reaction gas so as to activate the reaction gas by heating the reaction gas, and is classified into a low pressure type and a normal pressure type depending on the pressure employed. Further, the apparatus is classified into a low temperature type and a high temperature type depending on the substrate temperature, and furthermore, is classified into a resistance heating type, an induction heating type and a lamp heating type depending on the heating means. Further, it is classified into a hot wall type and a cold wall type depending on the location of installing the heating means.

Further, the light-assisted CVD apparatus includes light irradiation means for supplying energy to reaction gas so as to activate the reaction gas by irradiating the reaction gas with ultraviolet rays, and is able to form a film under low pressure or high pressure and at a low temperature.

Furthermore, the plasma-assisted CVD apparatus uses plasma generating means for activating reaction gas directly or indirectly using AC power or a magnetic field, and the plasma is generated under low pressure and at a low temperature in general. The plasma-assisted CVD apparatus is classified, depending on plasma generating means, into a parallel plate type for activating reaction gas directly by radiation of high-frequency power and an ECR type for supplying energy to electrons by high-frequency power and a magnetic field and activating reaction gas indirectly with these electrons.

Further, an etching apparatus, in particular a dry etching apparatus is a useful apparatus for manufacturing a semiconductor device in case of precise etching of a SiO₂ film, a PSG film, a BSG film, a BPSG film, a Si₃N₄ film, an amorphous Si film, a polycrystalline Si film, a W film, a Mo film, a WSi₂ film, a MoSi₂ film, an At film or the like, and is classified in an almost similar manner as the CVD apparatus described above.

In the CVD apparatus and the etching apparatus described above, a substrate holder for fixing a substrate to be processed is provided with a mechanical chuck, a vacuum chuck or an electrostatic chuck.

Further, since only a substrate and the peripheral portion are heated in a cold wall type in particular of the apparatus for manufacturing a semiconductor device described above, there is such an advantage that the reaction occurs in the peripheral portion, thus preventing reaction products from adhering to an inner wall of a reaction chamber. The heating means is provided below the substrate holder through an RF electrode or the like. In the case of the cold wall type, however, the substrate on the substrate holder is heated through an RF electrode or the like. Thus, although there is an advantage that large thermal capacity of the RF electrode or the like resists fluctuation of the substrate temperature once held, large electric power is consumed for heating the substrate. Further, when it is desired to change the substrate temperature, the above substrate holder cannot cope with the requirement in a short period of time and requires a long time until the substrate temperature is stabilized at the temperature to reach.

Furthermore, since reaction products are produced more or less in the apparatus for forming a film and the etching apparatus described above, they adhere to the inner wall of the reaction chamber and cause to generate particles or the like. Accordingly, it is required to remove these reaction products periodically. As a result, the throughput is decreased and a great amount of labor and cost are required.

US-A-5 084 125 discloses a reaction apparatus with a movable protective wall.

It is an object of the present invention to provide a substrate holder and a reaction apparatus capable of reducing power consumption for heating a substrate, changing a substrate temperature in a short period of time, preventing a lowering of the throughput, and reducing labor and cost for maintenance.

According to the present invention there is provided a reaction apparatus comprising: a processing chamber wall enclosing a processing chamber (7a) for processing a substrate (20) with processing gas; a substrate holder (12) in the chamber for holding said substrate (20); and a protective wall (7b) lying between said chamber wall and said substrate holder (12) for protecting the chamber wall (7a) against adhesion of reaction products, characterised in that the protective wall (7b) comprises overlapping upper (71a) and lower (71b) protective walls, said upper and lower protective walls being independently movable one with respect to the other, in the upward and downward direction.

In a preferred substrate holder an electrode of an electrostatic chuck and heating means are formed on a common base substance. Therefore, only the base substance of the substrate holder or the electrode of the electrostatic chuck lie between the held substrate and the heating means. Since the thermal capacity of the base substance of the substrate holder or the electrode of the electrostatic chuck is small, it is possible to reduce power consumption for heating the substrate, and further to change and stabilize the substrate temperature in a short period of time.

Further, a use of an electrostatic chuck for fixing the substrate is possible to use the substrate holder even in a reduced pressure, unlike the vacuum chuck. Furthermore, in a mechanical chuck, the substrate is damaged when the substrate is fixed by something like a clip or holding marks are left on the substrate surface, while a use of an electrostatic chuck can prevented it. Further, mounting and demounting of the substrate can be made more easily as compared with the mechanical chuck.

According to an embodiment of the reaction apparatus of the present invention, the above-mentioned substrate holder is provided. Therefore, it is possible to process the substrate in a reduced pressure, and mounting and demounting of the substrate can be made easily. Further, it is possible to aim at power saving and improvement of the throughput.

Further, the processing portion has a double structure composed of a chamber and a protective wall, and it is possible to remove the protective wall apart from the chamber, and to alternatively set new one as occasion demands.

Accordingly, when reaction products adhere to the inner wall of the protective wall, the inside of the processing portion is brought back to the atmospheric pressure, and the protective wall is taken out thereafter by moving the chamber upward and so on by elevating means such as a lift. The taken-out protective wall is cleaned so as to remove reaction products that have adhered to the inner wall of the protective wall. Furthermore, it is possible to continue processing in the processing portion during cleaning of the protective wall mentioned previously by setting another protective wall in place of the taken-out protective wall.

Further, it is possible to enlarge the contact area of the reaction products with the protective wall due to the fact that unevenness is formed on the surface of the protective wall so as to increase the adhesive power, thereby to prevent the reaction products that adhere to the protective wall during the period until replacement from peeling off.

Furthermore, it is possible to move the substrate holder up and down so as to maintain an appropriate space between a gas introductory implement installed above the substrate and the substrate by separating the protective wall into an upper protective wall and a lower protective wall and making it possible to move them up and down, respectively.

With this, it is not required to suspend the apparatus for a long period of time for cleaning the inside of the processing portion, thus making it possible to aim at the improvement of the throughput and to reduce labor and cost required for maintenance.

### BRIEF DESCRIPTION OF THE DRAWINGS

FIG. 1A is a side view showing the whole structure of a CVD apparatus using plasma in a helicon mode according to an embodiment of the present invention;
FIG. 1B is a sectional view of a protective wall of a CVD apparatus using plasma in a helicon mode according to an embodiment of the present invention;
FIG. 2 is a perspective view showing a detailed structure of an external antenna in a CVD apparatus using plasma in a helicon mode according to an embodiment of the present invention;
FIG. 3A is a sectional view showing details of a wafer holder according to an embodiment of the present invention;
FIG. 3B is a sectional view showing details of another wafer holder according to an embodiment of the present invention;
FIG. 4 is a side view showing a detailed structure of an elevating mechanism of a chamber lift and a wafer holder according to an embodiment of the present invention;
FIG. 5 is a side view showing how to remove a protective wall according to an embodiment of the present invention; and
FIG. 6 is a sectional view showing a protective wall.

### DESCRIPTION OF THE PREFERRED EMBODIMENT

Next, an embodiment of the present invention will be described with reference to the drawings.

### (1) Description of a reaction apparatus according to an embodiment of the present invention

### (A) Description of a CVD apparatus according to an embodiment of the present invention

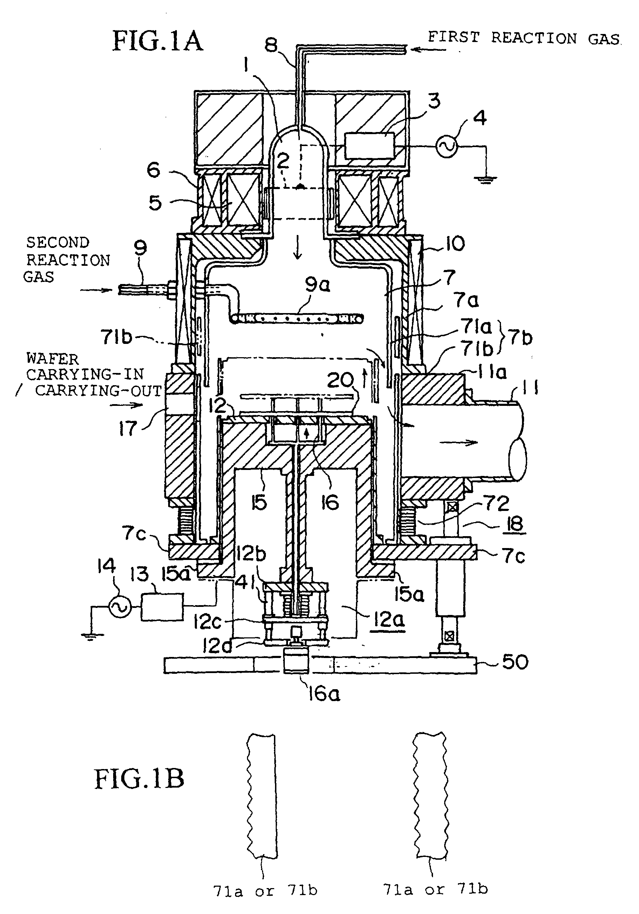

FIG. 1A is a side view showing the whole structure of a CVD apparatus according to an embodiment of the present invention. A CVD apparatus using plasma in a helicon mode is illustrated in the present embodiment..

In FIG. 1A, a reference numeral 1 represents a plasma generating portion partitioned from the outside with quartz having a cylindrical form 15 cm in diameter x 25 cm in length, which activates first reaction gas such as Ar+O₂ gas introduced through a first reaction gas introducing pipe 8. Further, the first reaction gas introducing pipe 8 is connected to an upper part of the plasma generating portion 1. Besides, the first reaction gas introducing pipe 8 may also be arranged so that a gas exhaust nozzle of the first reaction gas introducing pipe 8 is positioned at the central part of the plasma generating portion 1 so as to introduce the reaction gas into the plasma generating portion 1.

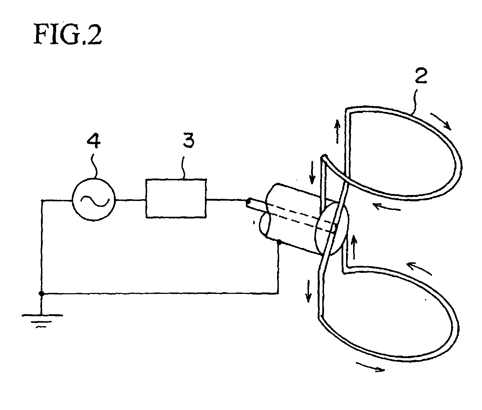

2 represents an external antenna fitted around the plasma generating portion 1. Two ring-shaped conductors run around the peripheral portions of the upper part and the lower part of the cylindrical plasma generating portion 1 at a predetermined space. The space between two ring-shaped conductors is important for adjusting a wave number of a helicon wave, i.e., plasma density. An example of the configuration of the external antenna 2 is shown in FIG. 2. In this case, RF currents are made to pass in two ring-shaped conductors in opposite directions, respectively, thus forming a helicon wave in a zero mode. Besides, it is also possible to form a helicon wave in a higher-order mode by changing the configuration of the external antenna.

3 represents a matching network connected to the external antenna 2, and 4 represents an RF power source for supplying RF power having a frequency of 13.56 MHz to the external antenna 2 through the matching network 3. The RF power serves as an energy source for generating plasma.

5 represents a cylindrical inner source solenoid provided around the plasma generating portion 1, 6 represents a cylindrical outer source solenoid provided around the inner source solenoid 5, and the inner source solenoid 5 and the outer source solenoid 6 form a magnetic field in an axial direction in the plasma generating portion 1. Such a magnetic field forms a helicon wave, and is deemed necessary for adjusting the plasma density.

The foregoing describes an apparatus structure of the plasma generating portion 1 and the peripheral portion thereof required for generating plasma of high density (10¹²cm⁻³ or higher) in a helicon mode, but, in particular, the RF power, the magnetic field and the space between two ring-shaped conductors of the external antenna 2 described above present important parameters for generating plasma.

7 represents a film-forming portion (a processing portion) that is partitioned from the outside by means of a cylindrical chamber 7a of 30 cm in diameter x 22.5 cm in length connected to the downstream of the plasma generating chamber 1, bellows 72 to be free in expansion and contraction, and a seal portion 7c.

The plasma in a helicon mode composed of the first reaction gas generated in the plasma generating portion 1 is supplied into the film-forming portion 7, and second reaction gas such as SiH₄ gas is also introduced into the film-forming portion 7 through a second reaction gas introducing pipe 9.

The second reaction gas introducing pipe 9 has a gas discharge portion 9a composed of a ring-shaped quartz pipe approximately 20 cm in diameter, and a plurality of gas discharge holes for discharging reaction gas onto a wafer 20 are formed in the quartz pipe. The second reaction gas introducing pipe 9 is arranged above the wafer 20 at a predetermined distance.

Further, the film-forming portion 7 has a double structure composed of a chamber 7a and a protective wall 7b. The detailed structure thereof will be described hereunder.

10 represents a chamber solenoid composed of a cylindrical permanent magnet provided around the film-forming portion 7, and it is made possible to apply an appropriate magnetic field to the film-forming portion 7. With this, the plasma is introduced into the film-forming portion 7 from the plasma generating portion 1, and the flowing configuration of the plasma is adjusted.

11 represents an exhaust port to which an exhaust unit is connected for exhausting disused and used reaction gas and for reducing pressure in the plasma generating portion 1 and the film-forming portion 7. The exhaust port 11 is provided in the film-forming portion 7.

12 represents a wafer holder (a substrate holder) provided in the lower part of the film-forming portion 7 for placing the wafer 20 thereon, and an electrostatic chuck for fixing the wafer 20 electrostatically by applying voltage and a heater for heating the wafer 20 are contained in a common insulating base substance. Further, the wafer holder is made to move up and down by means of an elevating mechanism 12a. The detailed structure of the wafer holder 12 will be described hereunder.

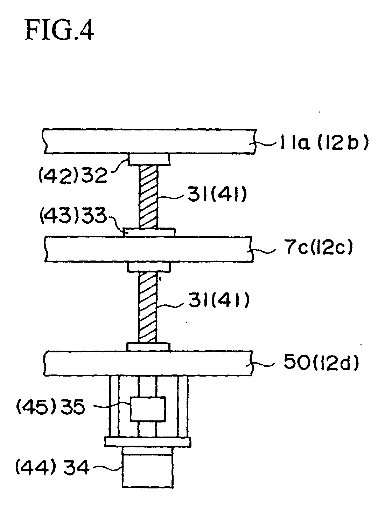

Next, the elevating mechanism 12a of the wafer holder 12 will be described with reference to FIG. 4.

In FIG. 4, 41 represents a ball screw for supporting a support plate 12b through a bearing support 42, and a tooth spirally running around a shaft is formed on the ball screw 41. Further, 43 represents a ball nut provided on a fixed plate 12c, which is engaged with the tooth of the ball screw 41 so as to support the ball screw 41 by the tooth spirally running around on the inner wall of a hole through which the ball screw 41 is inserted. The ball screw 41 moves up and down by rotating the ball screw 41.

44 represents a 5-phase stepping motor connected to the ball screw 41 through a helical coupling 45. The helical coupling 45 transmits the torque of the stepping motor 44 to the ball screw 41 by means of two helical gears.

The ball screw 41 is rotated by the stepping motor 44, thereby to move the wafer holder 12 up and down through the support plate 12b and an RF electrode 15. At this time, the bellows 72 provided between the chamber 7a and the seal portion 7c expand and contract, thus obtaining the inside of the film-forming portion 7 in a reduced pressure state.

15 represents an RF electrode provided in contact with the wafer holder 12 under the wafer holder 12, and an RF power source 14 for supplying electric power having a frequency of 13.56 MHz or 100 KHz is connected through a matching network 13. By applying electric power having a frequency of 13.56 MHz or 100 KHz to the wafer 20, negative self-bias D.C. voltage is applied to the wafer 20, thus optimizing the film quality such as the density and the stress of the formed film.

16 represents a wafer lift pin, which moves through the RF electrode 15 and a through hole of the wafer holder 12 by elevating means 16a, and pushes the wafer 20 up, thereby to pull apart the wafer 20 from the placing surface of the wafer holder 12. Then, the pulled apart wafer 20 is held by a wafer conveyor or the like not shown and taken out of a wafer carrying-in/carrying-out port 17.

18 represents a chamber lift (elevating means) for supporting a flange 11a of the exhaust port 11, moving the chamber 7a of the film-forming portion 7 upward through the flange 11a and pulling down the chamber 7a that has moved upward to the original position. Besides, although the chamber lift 18 is shown on one side only in the figure, it is also provided on another side normally for the purpose of supporting the chamber 7a in a balanced manner. The detailed structure thereof will be described hereunder.

50 represents a floor on which the chamber lift 18 and the CVD apparatus are installed.

According to a CVD apparatus related to the embodiment of the present invention, since the wafer holder 12 containing a heater and an electrostatic chuck inside is provided, it is possible to form a film on the wafer 20 in a reduced pressure, and mounting and demounting of the wafer are made easily. Further, it is possible to aim at power saving and improvement of the throughput.

### (B) Description of details of wafer holder according to an embodiment of the present invention

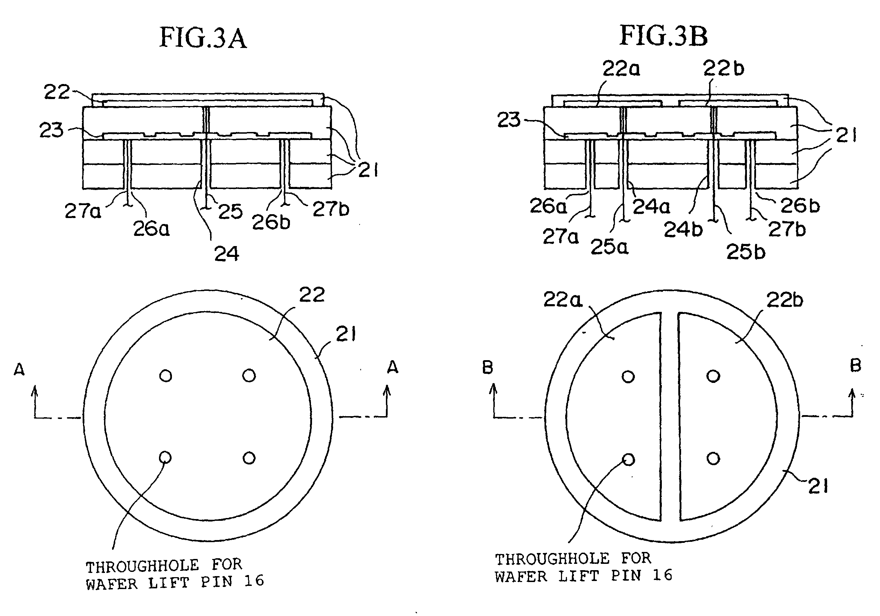

FIG. 3A shows details of the wafer holder 12 according to an embodiment of the present invention. The upper figure is a sectional view taken along a line A-A in a plan view thereunder.

In FIG. 3A, 21 represents a base substance composed of disc-shaped alumina ceramics or SiC, 22 represents an electrode for an electrostatic chuck buried in a planar form in the upper layer portion of the base substance 21, and it is possible to use tungsten (W), molybdenum (Mo) or platinum (Pt) as the material of the electrode 22. 23 represents a heater coil (heating means) separated electrically from the electrode 22 and buried in the base substance 21 under the electrode 22, 24 represents a via hole provided in the base substance 21 for taking out a lead wire 25 connected to the electrode 22 from under the wafer holder 12, and 26a and 26b represent via holes provided in the base substance 21 for taking out lead wires 27a and 27b connected to the heater coil 23 from under the wafer holder 12.

The structure of the electrode 22 of the electrostatic chuck includes, for example, a single pole type composed of one electrode as shown in FIG. 3A and a bipolar type composed of mutually separated two electrodes as shown in FIG. 3B.

In FIG. 3B, the upper figure shows a sectional view taken along a line B-B in a plan view thereunder. In FIG. 3B, those shown with the same reference numerals in FIG. 3A show the same articles as those shown in FIG. 3A, and other reference numerals 24a and 24b represent via holes provided in the base substance 21 for taking out lead wires 25a and 25b connected to electrodes 22a and 22b of the electrostatic chuck, respectively, from under the wafer holder 12.

Next, the operation of the electrostatic chuck having a single pole type electrode shown in FIG. 3A and the heater will be described.

First, the wafer 20 on which a film is to be formed is placed on the placing surface of the wafer holder 12. Then, the elevating mechanism 12a is operated so as to move the RF electrode 15 upward, and an appropriate space is maintained between the wafer holder 12 and the gas discharge portion 9a of the second reaction gas introducing pipe 9.

Then, D.C. voltage at 750 V for instance is applied to the electrode 22 of the electrostatic chuck through the lead wire 25. Since positive charges are supplied to the electrode 22 of the electrostatic chuck with the above, negative charges are induced on the wafer 20 by means of electrostatic induction. As a result, the wafer 20 is attracted toward the electrode 22 by coulombic attraction and fixed there.

Further, A.C. power including voltage component of approximately 220 V for instance is applied to the heater coil 23 through the lead wires 27a and 27b. Heat is generated in the heater coil 23 by the supply of electric power, and conducted in the base substance 21 by thermal conduction so as to heat the wafer 20.

For example, it requires approximately two hours until the temperature rises from the room temperature to 450°C and is stabilized, and it requires approximately one hour until the temperature falls from 450°C to the room temperature. The time required for temperature rise is shortened by a large margin as compared with that in the past.

When the temperature is stabilized, film-formation is commenced.

Thereafter, when film-formation is completed and the wafer 20 is taken out, supply of electric power to the heater coil 23 is kept as it is, and application of voltage to the electrostatic chuck is suspended, and electrostatic attraction is released, and the wafer 20 is pushed upward by means of the wafer lift pin 16 thereafter. Since the wafer 20 is separated from the wafer holder 12 with the foregoing, the wafer 20 is held by a wafer conveyor or the like and is carried out through the wafer carrying-in/carrying-out port 17. In case of necessity, supply of electric power to the heater coil 23 may be suspended.

As described above, the electrode 22 of the electrostatic chuck and the heater coil 23 are buried in an insulator in the wafer holder according to an embodiment of the present invention. Therefore, the wafer 20 and the heater coil 23 have only the ceramics of the wafer holder 12 or the electrode 22 for the electrostatic chuck therebetween. Since the thermal capacity of ceramics and the electrode 22 for the electrostatic chuck is small, it is possible to reduce power consumption for heating the wafer 20 and to change the temperature of the wafer 20 in a short period of time and stabilize the temperature.

Further, an electrostatic chuck being employed, it can be used even when a film is formed on the wafer 20 in a reduced pressure, being different from a vacuum chuck. Furthermore, the wafer is damaged or the holding marks are left on the wafer surface when the wafer is fixed with something like clip in the mechanical chuck, while a use of an electrostatic chuck prevent it. Further, mounting and demounting of the wafer 20 can be made more easily as compared with a mechanical chuck.

### (C) Description of details of film-forming portion according to an embodiment of the present invention

In FIG. 1A, the film-forming portion 7 is partitioned from the outside with the chamber 7a composed of quartz or a metal such as aluminum, and it is possible to reduce the pressure in the film-forming portion 7. Namely, the RF electrode 15 on which the wafer holder 12 is placed is provided in the lower part of the film-forming portion 7, and a hook-shaped seal portion 15a formed as one body with the RF electrode 15 and a seal portion 7c formed in the lower part of the chamber 7a are joined together through an insulator, thereby to seal the film-forming portion 7 hermetically. Furthermore, the bellows 72 being free in expansion and contraction are provided between the chamber 7a and the seal portion 7c. With this, even when the wafer holder 12 is moved up and down, the bellows 72 expand and contract, thus making it possible to maintain the inside of the film-forming portion 7 in a reduced pressure state.

Further, a cylindrical protective wall 7b is provided along the inner wall of the chamber 7a. The upper part of the cylinder communicates with the plasma generating chamber 1, and the lower part of the cylinder mounts on the seal portion 7c of the chamber 7a. Quartz is used as the material of the protective wall 7b, but alumina that is excellent in etching-proof performance may be used when etching gas is used as the reaction gas.

Furthermore, it is possible to remove the protective wall 7b separately from the chamber 7a. In case of necessity, it is possible to replace the wall 7b with a new protective wall. Further, the protective wall 7b is separated into an upper protective wall 71a and a lower protective wall 71b, and is formed of quartz or the like having different diameters. For example, the outside diameter of the upper protective wall 71a is smaller than the inside diameter of the lower protective wall 71b, a portion where these walls overlap each other slightly in a state that the wafer holder 12 is lowered to the maximum is produced, and these walls are set so that the overlapped portions lie one upon another. With this, when the wafer holder 12 is moved up and down together with the RF electrode 15, they move up and down in an overlapped state in accordance with the movement of the RF electrode 15. Furthermore, the upper protective wall 71a is engaged with the chamber 7a, and moves up and down, when the chamber 7a is moved up and down with the movement. Further, openings are provided in the protective wall 7b at locations corresponding to the inserting port of the second reaction gas introducing pipe 9, the exhaust port 11 and the wafer carrying-in/carrying-out port 17 of the chamber 7a.

This protective wall 7b prevents reaction products produced by the reaction of the reaction gas from adhering to the inner wall of the chamber 7a. Namely, the reaction products adhere to the inner wall of the protective wall 7b.

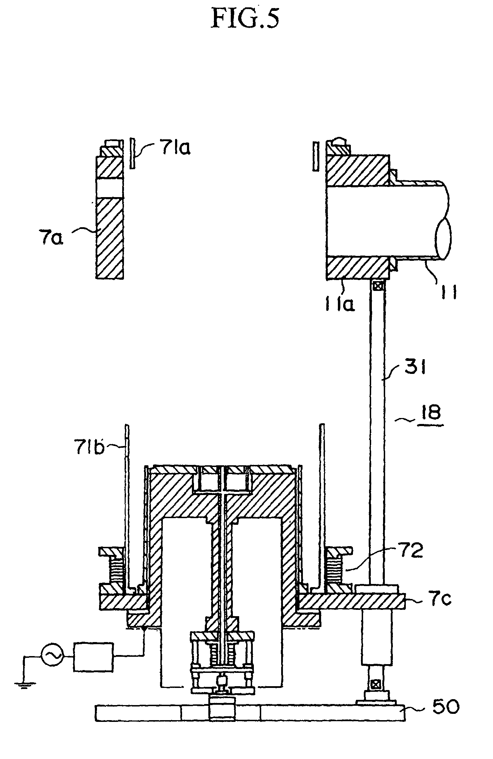

When the protective wall 7b is cleaned, the pressure inside of the film-forming portion 7 is returned to the atmospheric pressure and the second reaction gas introducing pipe 9 is removed, and thereafter, the chamber 7a is moved upward by means of the chamber lift 18 and the upper protective wall 71a and the lower protective wall 71b are taken out as shown in FIG. 5. The taken-out upper protective wall 71a and lower protective wall 71b are cleaned so as to remove the reaction products that have adhered to the inner wall or the outer wall of the upper protective wall 71a and the lower protective wall 71b.

It is possible to further continue to form a film in the CVD apparatus by setting another protective wall in place of the taken-out protective wall 7b. With this, it is not required to suspend the CVD apparatus over a long period of time for cleaning the inside of the film-forming chamber 7, thus making it possible to maintain the throughput and to reduce labor and cost required for maintenance.

Besides, when occasion demands, it is also possible to perform in-situ cleaning in which etching gas is introduced into the film-forming chamber 7 so as to etch the reaction products and remove them without taking out the protective walls 71a and 71b. Thus, it is possible to prevent the chamber 7a from being damaged by etching. Further, it is possible to accelerate etching so as to increase the effect of the in-situ cleaning by providing heating means around the chamber 7a and heating the protective walls 71a and 71b during cleaning.

Further, in order to increase the adhesive power of the reaction products to the protective walls 71a and 71b so that the reaction products that have adhered to the inner walls or the outer walls of the protective walls 71a and 71b do not peel off until replacement, unevenness may also be formed on the inner walls or the outer walls of the protective walls 71a and 71b so as to enlarge the contact area of the reaction products as shown in FIG. 1B.

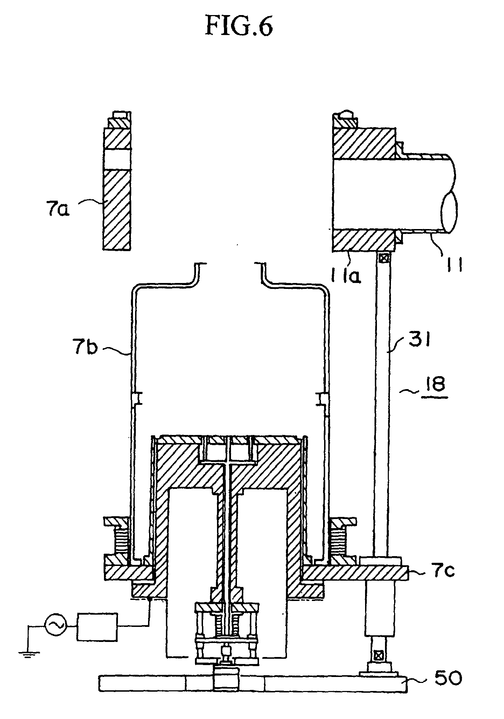

Fig. 6 shows a reaction apparatus with a protective wall formed in one body which is not part of the present invention.

### (D) Description of details of a chamber lift according to the embodiment of the present invention

FIG. 4 is a side view showing the details of a chamber lift according to an embodiment of the present invention.

In FIG. 4, 31 represents a ball screw (a support shaft) for supporting a flange 11a of an exhaust port 11 through a bearing support 32, and a tooth spirally running around the shaft is formed on the ball screw 31. Further, 33 represents a ball nut (a supporting base substance) fitted to the seal portion 7c of the chamber 7a, which is engaged with the tooth of the ball screw 31 so as to support the ball screw 31 by the tooth spirally running around on the inner wall of a hole through which the ball screw 31 is inserted. The ball screw 31 moves up and down by rotating the ball screw 31.

34 represents a 5-phase stepping motor (driving means) connected to the ball screw 31 through a helical coupling 35. The helical coupling 35 transmits the torque of the stepping motor 34 to the ball screw 31 with two helical gears engaged with each other.

The ball screw 31 is rotated by means of the stepping motor 34, thereby to move the chamber 7a of the film-forming chamber 7 up and down through the flange 11a of the exhaust port 11.

In particular, it is used when the heavy chamber 7a is opened and closed for the purpose of replacing the protective wall 7b.

Besides, the present invention is applied to the CVD apparatus in the above-mentioned embodiment, but the present invention is also applicable to the etching apparatus.

Further, the wafer holder 12 is placed on the RF electrode 15 for biasing the wafer 20, but it may also be installed on one RF electrode among opposing RF electrodes for activating the reaction gas.

### (2) Description of a method of forming a film using a CVD apparatus according to an embodiment of the present invention

Next, the operation of the above-mentioned CVD apparatus will be described briefly with reference to FIG. 1A.

First, the wafer (substrate) 20 is placed on the wafer holder 12 and fixed electrostatically by the electrostatic chuck, and the pressure in the film-forming chamber 7 is reduced thereafter. Furthermore, as occasion demands, electric power is applied to the heater coil 23 contained in the wafer holder 12 so as to heat the wafer 20, thus maintaining the wafer at a temperature at approximately 200 to 500°C. Further, electric power having a frequency of 13.56 MHz or 100 KHz is supplied to the RF electrode 15, thereby to apply negative self-bias D.C. voltage to the wafer 20 through the wafer holder 12. With this, the film quality such as the density and the stress of the formed film is optimized.

Then, oxygen (O₂) gas or mixed gas of O₂+Ar is introduced into the decompressed plasma generating chamber 1. Further, electric power having a frequency of 13.56 MHz is supplied to the external antenna 2 by means of the RF power source 4 through the matching network 3. With this, an RF current passing around the plasma generating chamber 1 is applied in two ring-shaped conductors of the external antenna 2 in opposite directions, respectively, thereby to radiate an electromagnetic wave. Furthermore, an electric current is supplied to the inside source solenoid 5 and the outside source solenoid 6 so as to generate an axial magnetic field.

With the foregoing, a helicon wave is excited, the oxygen gas in the plasma generating chamber 1 is activated, and plasma of high density (10¹²cm⁻³ or higher) in a helicon mode is generated.

The generated plasma moves to the decompressed film-forming chamber 7 in downstream by the magnetic field and activates SiH₄ gas supplied onto the wafer 20. With this, the activated SiH₄ gas reacts on the oxygen plasma, and a silicon oxide film is accumulated on the wafer 20.

According to the CVD apparatus described above, the external antenna 2 connected with the RF power source 4 or the like is provided, and the RF power having a frequency of 13.56 MHz is supplied, thereby to generate plasma. Thus, the equipment such as a waveguide required in the case of ECR method is not required, and the apparatus structure becomes simpler. Further, since it is possible to use a frequency lower than the frequency of 2.45 GHz in the case of ECR method, it is easy to generate high frequency electric power.

Further, since the first reaction gas introducing pipe 8 for introducing the oxygen gas and the second reaction gas introducing pipe 9 for introducing the SiH₄ gas are separated from each other, the reaction between the reaction gases during supply is restricted, and generation of particles is reduced. Provided that all of the gas may be introduced through the first reaction gas introducing pipe 8 if circumstances require.

As described above, the electrode 22 of the electrostatic chuck and the heating means 23 are formed in the common base substance 21 in the substrate holder according to the present invention. Further, this substrate holder 12 is provided in the reaction apparatus.

Thus, only the base substance 21 of the substrate holder 12 or the electrode 22 of the electrostatic chuck lies between the held substrate 20 and the heating means 23. As a result, it is possible to reduce power consumption for heating the substrate, and to change the substrate temperature in a short period of time.

Further, the processing portion 7 has a double structure composed of the chamber 7a and the protective wall 7b, thus making it possible to take out the protective wall 7b separately from the chamber 7a and to replace it.

Accordingly, when reaction products have adhered to the inner wall of the processing portion 7, the protective wall 7b is taken out by removing the chamber 7a, and the protective wall 7b is cleaned so as to remove the reaction products from the inner wall thereof. In this case, it is possible to continue processing in the manufacturing apparatus during cleaning of the protective wall mentioned previously by setting another protective wall in place of the taken-out protective wall 7b. With this, it is not required to suspend the apparatus for many hours for cleaning the inside of the processing portion 7, thus making it possible to maintain the throughput and to reduce labor and cost required for maintenance.

## Claims

1. A reaction apparatus comprising: a processing chamber wall enclosing a processing chamber (7a) for processing a substrate (20) with processing gas; a substrate holder (12) in said chamber, for holding said substrate (20); and a protective wall (7b) lying between said chamber wall and said substrate holder (12) for protecting the chamber wall against adhesion of reaction products, **characterised in that** the protective wall (7b) comprises overlapping upper (71a) and lower (71b) protective walls, said upper and lower protective walls being independently movable one with respect to the other, in the upward and downward direction.

2. A reaction apparatus according to Claim 1 wherein said protective wall (7b) is removable.

3. A reaction apparatus according to Claim 1 or 2 wherein unevenness is formed on the inner surface of said protective wall (7b).

4. A reaction apparatus according to Claim 1, 2 or 3 further comprising elevating means (18) for moving said chamber (7a) upward and pulling down to an original position said chamber (7a) that has been moved upward.

5. A reaction apparatus according to Claim 4 wherein said elevating means (18) includes:
a support shaft (31) for supporting said chamber (7a), on which a tooth spirally running around the axis is formed;
a support base substance (7c) for supporting said support shaft (31) inserted in a hole formed in said support base substance (33), said hole having a tooth spirally running around the axis on an inner wall thereof, said tooth being engaged with the tooth of said support shaft (31); and
driving means (34) for rotating said support shaft (31).

6. A reaction apparatus according to any preceding claim, wherein said substrate holder (12) is provided on an electrode (15) for applying an A.C. electric signal for activating said processing gas or biasing said held substrate (20).

7. A reaction apparatus according to claim 1, wherein said reaction apparatus is a CVD apparatus using plasma in a helicon mode.

8. A reaction apparatus as claimed in any preceding claim, the substrate holder further having an electrode (22) for attracting a substrate (20) electrostatically and heating means (23) for heating said substrate (20) and which are formed in a common base substance (21).

## Patentansprüche

1. Reaktionsapparat, der aufweist: eine Verarbeitungskammerwand, die eine Verarbeitungskammer (7a) zur Verarbeitung eines Substrats (20) mit Prozeßgas umgibt; einen Substrathalter (12) in der Kammer zur Aufnahme des Substrats (20); und eine Schutzwand (7b), die zwischen der Kammerwand und dem Substrathalter (12) liegt, um die Kammerwand gegen Anhaften von Reaktionsprodukten zu schützen, **dadurch gekennzeichnet, daß** die Schutzwand (7b) einander überlappende obere (71a) und untere (71b) Schutzwände aufweist, wobei die unteren und oberen Schutzwände unabhängig voneinander nach oben und unten beweglich sind.

2. Reaktionsapparat nach Anspruch 1, wobei die Schutzwand (7b) abnehmbar ist.

3. Reaktionsapparat nach Anspruch 1 oder 2, wobei an der Innenfläche der Schutzwand (7b) eine Unebenheit ausgebildet ist.

4. Reaktionsapparat nach Anspruch 1, 2 oder 3, der ferner eine Hubeinrichtung (18) aufweist, um die Kammer (7a) aufwärts zu bewegen und die aufwärts bewegte Kammer (7a) abwärts in eine Ausgangsstellung zu ziehen.

5. Reaktionsapparat nach Anspruch 4, wobei die Hubeinrichtung (18) aufweist:
eine Trägerwelle (31) zum Unterstützen der Kammer (7a), an der eine Spiralverzahnung um die Achse herum ausgebildet ist;
einen Trägerkörper (7c) zur Aufnahme der Trägerwelle (31), die in eine in dem Trägerkörper angebrachte Bohrung (33) eingesetzt wird, wobei die Bohrung an ihrer Innenwand eine Spiralverzahnung um ihre Achse herum aufweist, wobei die Verzahnung mit der Verzahnung der Trägerwelle (31) im Eingriff ist; und
eine Antriebseinrichtung (34) zum Drehen der Trägerwelle (31).

6. Reaktionsapparat nach einem der vorstehenden Ansprüche, wobei der Substrathalter (12) auf einer Elektrode (15) angebracht ist, um ein elektrisches Wechselstromsignal zum Aktivieren des Prozeßgases oder zum Vorspannen des aufgenommenen Substrats (20) anzulegen.

7. Reaktionsapparat nach Anspruch 1, wobei der Reaktionsapparat eine chemische Aufdampfvorrichtung (CVD-Vorrichtung) mit Verwendung von Plasma in Helicon-Betriebsart ist.

8. Reaktionsapparat nach einem der vorstehenden Ansprüche, wobei der Substrathalter ferner eine Elektrode (22) zur elektrostatischen Anziehung eines Substrats (20) und eine Erhitzungsvorrichtung (23) zum Erhitzen des Substrats (20) aufweist, die in einem gemeinsamen Trägerkörper (21) ausgebildet sind.

## Revendications

1. Dispositif à réaction comprenant: une paroi de chambre de traitement renfermant une chambre de traitement (7a) destinée à traiter un substrat (20) à l'aide d'un gaz de traitement; un porte-substrat (12) dans ladite chambre, destiné à supporter ledit substrat (20); et une paroi protectrice (7b), se trouvant entre ladite paroi de chambre et ledit porte-substrat (12), destinée à protéger la paroi de chambre contre l'adhérence des produits de réaction, **caractérisé en ce que** la paroi protectrice (7b) comprend des parois protectrices supérieure (71a) et inférieure (71b) chevauchantes, lesdites parois protectrices supérieure et inférieure étant mobiles indépendamment l'une par rapport à l'autre, selon la direction montante et descendante.

2. Dispositif à réaction selon la revendication 1, dans lequel ladite paroi protectrice (7b) est amovible.

3. Dispositif à réaction selon la revendication 1 ou 2, dans lequel des irrégularités sont formées sur la surface intérieure de ladite paroi protectrice (7b).

4. Dispositif à réaction selon la revendication 1, 2 ou 3, comprenant en outre un moyen élévateur (18) destiné à déplacer vers le haut ladite chambre (7a) et à tirer vers le bas à une position d'origine ladite chambre (7a) qui a été déplacée vers le haut.

5. Dispositif à réaction selon la revendication 4, dans lequel ledit moyen élévateur (18) comprend:
un arbre de support (31) destiné à supporter ladite chambre (7a), sur lequel est formée une dent s'étendant en spirale autour de l'axe;
une substance de base de support (7c) destinée à supporter ledit arbre de support (31) inséré dans un trou formé dans ladite substance de base de support (33), ledit trou comportant une dent s'étendant en spirale autour de l'axe sur sa paroi intérieure, ladite dent étant en prise avec la dent dudit arbre de support (31); et
un moyen d'entraînement (34) destiné à mettre en rotation ledit arbre de support (31).

6. Dispositif à réaction selon l'une quelconque des revendications précédentes, dans lequel ledit porte-substrat (12) est disposé sur une électrode (15) destinée à appliquer un signal électrique alternatif pour activer ledit gaz de traitement ou pour polariser ledit substrat supporté (20).

7. Dispositif à réaction selon la revendication 1, dans lequel ledit dispositif à réaction est un dispositif de dépôt chimique en phase vapeur (DCPV) utilisant un plasma en mode hélicon.

8. Dispositif à réaction selon l'une quelconque des revendications précédentes, le porte-substrat comportant en outre une électrode (22) destinée à attirer de façon électrostatique un substrat (20) et un moyen de chauffage (23) destiné à chauffer ledit substrat (20), qui sont formés dans une substance de base commune (21).
